# EUROPEAN PATENT SPECIFICATION

(11) **EP 0 497 819 B1**
(45) Date of publication and mention of the grant of the patent: **10.04.1996**
(21) Application number: 90915652.3
(22) Date of filing: 11.10.1990
(51) Int. Cl.: G03C 1/805, G03C 1/91, G03F 7/11

(54) **A RELEASE LAYER FOR AN AQUEOUS OR SEMI-AQUEOUS PROCESSIBLE FLEXOGRAPHIC PRINTING PLATE**
ABZIEHSCHICHT FÜR WÄSSRIG ODER HALBWÄSSRIG ENTWICKELBARE FLEXODRUCKPLATTEN
COUCHE DE DEGAGEMENT POUR PLAQUE D'IMPRESSION FLEXOGRAPHIQUE POUVANT ETRE TRAITEE PAR DES SOLUTIONS AQUEUSES OU SEMI-AQUEUSES

(30) Priority: 31.10.1989 US 429584
(43) Date of publication of application: 12.08.1992
(73) Proprietor: E.I. DU PONT DE NEMOURS AND COMPANY, Wilmington Delaware 19898 (US)
(72) Inventor: SWATTON, David, William, Red Bank, NJ 07701 (US)
(74) Representative: von Kreisler, Alek, Dipl.-Chem.
(86) International application number: US9005663
(87) International publication number: WO9106893

(56) References cited:
- EP-A- 0 356 954
- WO-A-80/02879
- DE-B- 1 086 999
- GB-A- 1 165 664
- GB-A- 1 462 511
- US-A- 4 576 897
- Patent Abstracts of Japan, Vol 12, No 497, P806, abstract of JP 63-206747, publ 1988-08-26

## Description

### A Release Layer For An Aqueous or Semi-Aqueous Processible Flexographic Printing Plate

### FIELD OF THE INVENTION

This invention relates to release layers for flexographic printing plates and, more particularly, to hydroxyalkyl cellulose release layers for aqueous or semi-aqueous processible flexographic printing plates.

### BACKGROUND OF THE INVENTION

Release layers facilitate removal of a negative or positive image-bearing film from a flexographic printing element after the element has been imagewise exposed through the negative or positive film. In the absence of a release layer, the film usually sticks to the tacky surface of the printing element which makes it virtually impossible to remove the film without damaging the surface of the element.

Typically, polyamide release layers are used in making flexographic printing elements which are developable in non-aqueous solvents. However, polyamide release layers are not suitable for use with aqueous or semi-aqueous developable flexographic printing elements because they are not sufficiently soluble in the developer solutions.

Release layers which are sufficiently soluble in the solutions used to develop aqueous or semi-aqueous flexographic printing elements have been described in U.S. Patent No. 4,576,897 and in applicant's copending patent application, EP-A-0 356 954. Both documents disclose the use of polyvinyl alcohol release layers while the former, at col. 3, l. 47-51, mentions cellulose derivatives as possible alternative release layer substances.

One of the problems associated with the aqueous or semi-aqueous developable release layers described above is that the resulting image quality, in particular, the reverse line and dot depths achievable, is inferior to the image quality previously obtained using polyamide release layers.

It is therefore desirable to provide an aqueous or semi-aqueous developable release layer which when used with an aqueous or semi-aqueous processible flexographic printing element results in an image quality which heretofore has not been possible to obtain using a polyvinyl alcohol release layer.

### SUMMARY OF THE INVENTION

This invention relates to a method to facilitate removal of a negative or positive image-bearing film from an aqueous or semi-aqueous processible flexographic printing element which comprises using a hydroxyalkyl cellulose release layer interposed between the image-bearing film and a photosensitive layer of the element, wherein the alkyl group has from one to five carbon atoms.

This invention also concerns an aqueous or semi-aqueous processible flexographic photosensitive element containing this release layer and to processes for making printing reliefs from such elements.

### DETAILED DESCRIPTION OF THE INVENTION

Release layers which are suitable to use with aqueous or semi-aqueous processible flexographic printing elements should have the following characteristics: (a) they must be soluble or swellable in the developer solvent, (b) they be must be substantially incompatible with the ethylenically unsaturated monomers used to formulate the photosensitive layer of the flexographic printing element, (c) they should not adversely affect image quality, and (d) they must be flexible. Furthermore, as one skilled in the art can appreciate, the release layer should be transparent, coatable, non-tacky, and, yet, have sufficient adhesion to the layers between which it is interposed.

It has been found that incorporating an hydroxyalkyl cellulose release layer facilitates the removal of a negative or positive image-bearing film from an aqueous processible flexographic printing element. Surprisingly and unexpectedly, the hydroxyalkyl cellulose release layer possesses the necessary characteristics described above.

The alkyl moiety has from one to five carbon atoms and can be linear or branched. Propyl is the preferred alkyl moiety.

Hydroxyalkyl cellulose release layers are easily removed by dilute aqueous alkaline solutions. They are substantially incompatible with ethylenically unsaturated monomers used to formulate flexographic printing elements. This incompatibility prevents the monomers from leaching into the release layer which would render the layer tacky. The image quality, i.e., reverse line and dot depths, obtained is superior to that obtained using polyvinyl alcohol release layers. If the reverse line and dot depths are inadequate, then inking occurs in areas which should not be inked.

Furthermore, the hydroxyalkyl cellulose release layer is substantially transparent, non-tacky, easily coated using a conventional bar coating apparatus, and has sufficient adhesion to both the photosensitive layer and to the cover sheet. By sufficient adhesion it is meant that the release layer remains adhered to both layers during normal handling and that the cover layer is easily removed prior to imagewise exposing.

A surfactant can be added, if necessary, to the release layer in order to improve coating/wetting of the release layer on the flexible cover sheet. Any surfactant can be used as long as it is processible in an aqueous or semi-aqueous system. There can be mentioned fluorinated surfactants, such as, perfluoroalkyl ethoxylate. Usually, at least 1.0% of surfactant should be present based on the total weight of the release composition. Preferably, at least 2.5% of surfactant should be present.

In addition to a surfactant, a colorant can also be added to the release layer to facilitate detection of coating defects. Any colorant which is soluble in an aqueous or semi-aqueous system can be used.

In general, an aqueous or semi-aqueous processible flexographic element comprises a support, a layer of a photosensitive composition, said composition comprising an aqueous or semi-aqueous processible binder, at least one addition polymerizable ethylenically unsaturated monomer, an initiator or initiating system activated by actinic radiation and a flexible cover sheet.

The hydroxyalkyl cellulose release layer can be applied on top of the photosensitive composition in a variety of ways. The preferred method is to bar coat a thin layer onto the side of the flexible cover sheet which contacts the photosensitive composition layer. The release layer has a dry coating weight in the range 10 mg/dm to 80 mg/dm. The photosensitive composition can then be extruded between the cover sheet coated with the release composition and a support. When the cover sheet is removed, the release layer remains on the surface of the photosensitive layer and a substantially smooth surface is exhibited.

The photopolymerizable layers described herein can be applied to a wide variety of substrates. By substrate is meant any natural or synthetic support. For example, suitable base or support materials include metals, e.g., steel and aluminum plates, sheets and foils, and films or plates composed of various film-forming synthetic resins or high polymers, such as the addition polymers and in particular vinylidene chloride copolymers with vinyl chloride, vinyl acetate, styrene, isobutylene and acrylonitrile; vinyl chloride homopolymers and copolymers with vinyl acetate, styrene, isobutylene and copolymers with vinyl acetate, styrene, isobutylene and acrylonitrile; linear condensation polymers such as polyesters, e.g., polyethylene terephthalate, polyamide, e.g., polyhexamethylenesebacamide; polyimides, e.g., films as disclosed in assignee's Edwards, U.S. Patent No. 3,179,634 and polyester amide, e.g., polyhexamethylenedipamide adipate. Fillers or reinforcing agents can be present in the synthetic resin or polymer basis such as the various fibers (synthetic modified, or natural), e.g., cellulosic fibers, for instance, cotton, cellulose acetate, viscose rayon, paper; glass wool; nylon and polyethylene terephthalate. These reinforced bases may be used in laminated form. Various anchor layers disclosed in U.S. Patent No. 2,760,863 can be used to give strong adherence between the support and the photosensitive layer or, in the case of transparent support, pre-exposure through the support to actinic radiation may be useful. The adhesive compositions disclosed in assignee's Burg, U.S. Patent No. 3,036,913, are also effective.

Photopolymer compositions suitable for use in this invention should be developable in water or aqueous or semi-aqueous alkali. The photopolymer compositions comprise a preformed macromolecular polymeric binder, at least one addition polymerizable ethylenically unsaturated monomer, and an initiating system. Photosensitive compositions such as those taught in Alles U.S. Patent 3,458,311, Pohl, U.S. Patent 4,442,302, Pine, U.S. Patent 4,361,640, Kai et al., U.S. Patent 3,794,494, Proskow et al., U.S. Patents 4,177,074, 4,431,723 and 4,272,608 and Worns, U.S. Patent 4,517,279, all of which are hereby incorporated by reference, are suitable for use in practicing the present invention.

In addition to the photopolymer compositions mentioned above, photopolymer compositions using binders consisting of a core-shell microgel or a blend of a preformed macromolecular polymer and a core shell microgel such as those described in applicant's assignee's copending patent application filed on August 30, 1988, S.N. 07/238,104, attorney docket number IM-0172, incorporated herein by reference. The term core-shell microgel means a particle having two domains--a crosslinked core and an aqueous processible non-crosslinked shell. The core should have less than 10% crosslinking and the shell consists of an acid-modified copolymer which is not crosslinked.

Core shell microgels are conventionally prepared by emulsion polymerization. The microgels are generally formed from 90 to 99.5% by weight polymer component and 10 to 0.5% by weight crosslinking agent with these materials compatible in formation of a continuous phase system. The polymer components can be varied during polymerization to produce core and shell microgel so that the core has less than 10% crosslinking and the shell is designed for aqueous processibility in that an acid-modified copolymer is used to make the shell. Typically, the microgels used have elastomeric crosslinked cores and aqueous processible elastomeric non-crosslinked shells or a thermoplastic non-crosslinked shell. Elastomers, by definition, have glass transition temperatures below room temperature and thermoplastic materials, by definition, have glass transition temperatures above room temperature. It is also possible to use a microgel having a thermoplastic crosslinked core and a thermoplastic non-crosslinked shell. The choice will depend upon the use to which the photosensitive composition is to be put. A preferred microgel has an elastomeric crosslinked core and an elastomeric non-crosslinked shell.

Core shell microgels can be made from a wide variety of starting materials. Conventionally, mono- or poly-ethylenically unsaturated monomers are used in preparing the bulk portion of the microgel, whereas the crosslinking agents contain at least two double bonds.

Suitable monomers are esters of acrylic and methacrylic acid with C₁-C₁₈ alcohols. There can be mentioned methyl methacrylate, ethyl acrylate, methacrylic acid, butyl methacrylate, ethyl methacrylate, glycidyl methacrylate, styrene and allyl methacrylate, while other useful monomers include acrylonitrile, methacrylonitrile, acrylic acid, butadiene (BD) and 2-ethylhexyl acrylate. The preferred monomer for making the core is 2-ethylhexyl acrylate. The preferred acid-modified copolymer for the shell is a methacrylic acid-modified n-butyl acrylate.

Other suitable monomers include vinyl ethers and vinyl esters, nitriles and amides of acrylic and methacrylic acid.

A preferred crosslinking agent is butanediol diacrylate (BDDA); while others include ethylene glycol dimethacrylate, tetramethylene glycol diacrylate, trimethylol propane triacrylate, tetraethylene glycol dimethacrylate, methylene bisacrylamide, methylene bismethacrylamide, divinyl benzene, vinyl methacrylate, vinyl crotonate, vinyl acrylate, vinyl acetylene, trivinyl benzene, glycerine trimethacrylate, pentaerythritol tetramethacrylate, triallyl cyanurate, divinyl acetylene, divinyl ethane, divinyl sulfide, divinyl sulfone, dienes such as butadiene, hexatriene, triethylene glycol dimethacrylate, diallyl cyanamide, glycol diacrylate, ethylene glycol divinyl ether, diallylphthalate, divinyl dimethyl silane, glycerol trivinyl ether and the like.

As was mentioned previously, crosslinking is controlled during manufacture. Thus, core shell microgels having cores with less than 10% crosslinking is accomplished by using 10% or less of the crosslinking agent to crosslink the core, i.e., no crosslinking agent is used to make the shell.

Conventionally, one or more monomers and crosslinking agents are dispersed in water with suitable emulsifiers and initiators in manufacture of the microgel. Conventional anionic, cationic or nonionic emulsifiers and water soluble initiators can be employed. Examples of emulsifying agents are sodium lauryl sulfate, lauryl pyridine chloride, polyoxyethylene, polyoxypropylene, colloidal silica, anionic organic phosphates, magnesium montmorillonite, the reaction product of 12 to 13 moles of ethylene oxide with 1 mole of octyl phenol, secondary sodium alkyl sulfates and mixtures thereof. Usually from 0.25 to 4% of emulsifier based on the total weight of reactants is used. Examples of initiators are potassium persulfate, sodium persulfate, ammonium persulfate, tertiary butyl hydroperoxide, hydrogen peroxide, azo bis(isobutyronitrile), azo bis(isobutyroimidine hydrochloride), various redox (reduction-oxidation) systems such as hydrogen peroxide and ferrous sulfate and well known persulfate-bisulfate combinations. Usually from 0.05 to 5% by weight of initiator based on the weight of copolymerizable monomers is used.

Microgels can be produced by the technique of emulsion polymerization as described in U.S. Pat. No. 3,895,082. (Also, British Pat. No. 967,051 teaches a suitable method.) This technique can also be modified by beginning the reaction with one set of monomers and by varying the ratios for the final part of the reaction in order to produce spherical microgels in which the inner part of the polymer, i.e., the core is a different monomeric composition than the outer part of the polymer, i.e., shell. It is also desired that the shell be designed for aqueous processibility. This is achieved by constructing the shell so that it has an acid-modified copolymer. The core can be elastomeric while the shell can be either elastomeric or thermoplastic.

The art of emulsion polymerization is well known concerning reaction conditions to produce spherical microgels dispersed in a water phase. Unless the dispersion can be used as made and contain no objectionable impurities or byproducts, it is usually necessary to convert the microgels to a solid prior to their use as a photosensitive composition. Well-known techniques of coagulation, filtration, washing and drying can be employed for this purpose. Freeze drying is a particularly useful method for the present invention. Generally the amount of crosslinking agent in the microgel will be less than 20% by weight of the overall weight of the microgel and generally less than 10% by weight.

The weight ratio of the core to the shell is usually in the range from about 4:1 to about 1:4.

Compositions of some of the microgels produced and tested and found useful are set forth in Table 1. All parts are by weight.

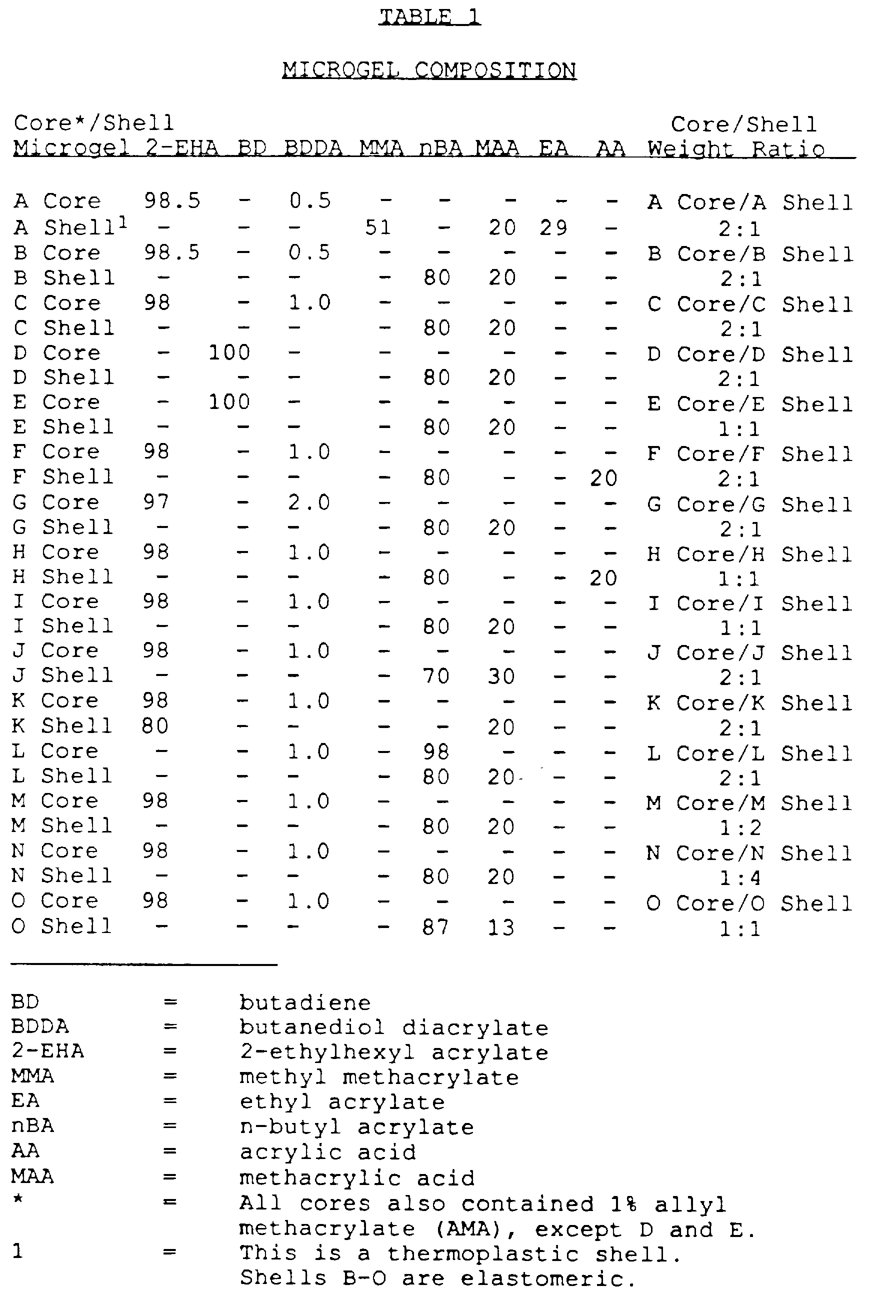

Preformed macromolecular polymers which can be used in a blend with a microgel contain sufficient acidic or other groups so that the binder is also processible in a semi-aqueous or aqueous developer. Useful aqueous-processible binders include those disclosed in U.S. Pat. No. 3,458,311 and in U.S. Pat. No. 4,273,857. Useful amphoteric polymers include interpolymers derived from N-alkylacrylamides or methacrylamides, acidic film-forming comonomer and an alkyl or hydroxyalkyl acrylate such as those disclosed in U.S. Pat. No. 4,293,635. For aqueous development, those portions of the photosensitive layer which have not been exposed to radiation will be removed during development by a liquid such as wholly aqueous solutions containing 2% sodium carbonate by weight. The exposed portions will not be affected by development.

Generally, the binder will be present in an amount from 1 to 90% by weight of the components as mentioned above.

An example of suitable concentrations by weight in a photosensitive composition based on these constituents is:
(a) from 5% to 50% of an addition polymerizable ethylenically unsaturated monomer;
(b) from 0.01% to 15% of an initiating system activated by actinic radiation;
(c) from 1% to 90% by weight of a binder.

If a plasticizer is needed, it can be any one of the common plasticizers compatible with the microgel binder. Some of the common plasticizers which can be used are dialkyl phthalates, alkyl phosphates, polyethylene glycol, polyethylene glycol esters, polyethylene glycol ethers, and low molecular weight polybutadienes (MW<5000).

When a blend of a core shell microgel and a preformed macromolecular polymer is used, it is preferred that the addition polymerizable ethylenically unsaturated monomer should partition outside the core of the microgel. Suitable monomers can be selected, generally, which have chemical compositions similar to the chemical composition of the aqueous processible outer shell. One class of suitable ethylenically unsaturated esters of alcohols. The following can also be mentioned: trimethylolpropane triacrylate, polyoxyethylated trimethylolpropane triacrylate.

Preferred free radical-generating addition polymerization initiators activatable by actinic light and thermally inactive at and below 185°C include the substituted or unsubstituted polynuclear quinones which are compounds having two intracyclic carbon atoms in a conjugated carbocyclic ring system, e.g., 9,10-anthraquinone, 1-chloroanthraquinone, 2-chloroanthraquinone, 2-methylanthraquinone, 2-ethylanthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2,3-diphenylanthraquinone, sodium salt of anthraquinone alpha-sulfonic acid, 3-chloro-2-methylanthraquinone, retenequinone, 7,8,9,10-tetrahydro-naphthacenequinone, and 1,2,3,4-tetrahydrobenz(a)anthracene-7,12-dione, and dimethoxyphenylacetophenone. Other photoinitiators which are also useful, even though some may be thermally active at temperatures as low as 85°C, are described in U.S. Pat. No. 2,760,863 and include vicinal ketaldonyl alcohols, such as benzoin, pivaloin, acyloin ethers, e.g., benzoin methyl and ethyl ethers; alpha-hydrocarbon-substituted aromatic acyloins, including alpha-methylbenzoin, alpha-benzoin and alpha-phenylbenzoin. Photoreducible dyes and reducing agents disclosed in U.S. Pat. Nos. 2,850,445; 2,875,047; 3,097,096;3,074,974; 3,097,097; and 3,145,104, as well as dyes of the phenazine, oxazine, and quinone classes; Michler's ketone, benzophenone, 2,4,5-triphenyl-imidazolyl dimers with hydrogen donors, and mixtures thereof as described in U.S. Pat. Nos. 3,427,161; 3,479,185; and 3,549,367 can be used as initiators. Similarly the cyclohexadienone compounds of U.S. Pat. No. 4,341,860 are useful as initiators. Also useful with photoinitiators and photoinhibitors are sensitizers disclosed in U.S. Pat. No. 4,162,162.

Thermal polymerization inhibitors that can be used in photopolymerizable compositions are: p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6-di-tert-butyl-p-cresol, phenothiazine, pyridine, nitrobenzene and dinitrobenzene, p-toluquinone and chloranil. Also useful for thermal polymerization inhibitors are the nitroso compositions disclosed in U.S. Pat. No. 4,168,982.

A transparent cover sheet such as a thin film of polystyrene, polyethylene, polypropylene or other strippable material is generally present on top of the release layer to prevent contamination or damage during storage or manipulation.

In general, the process of preparing a flexographic printing plate from a photopolymer element includes the steps of main image exposure, development or washout, drying and, optionally, post-development treatment, e.g., post-exposure. Detackification is an optional post-development treatment which can be applied if the surface is still tacky.

A backflash exposure may be used with elements having a transparent support. Backflash generally uses a radiation source emitting a principal wavelength around 360 nm. It serves to sensitize the plate and establishes the depth of the plate relief. The backflash procedure gives the photopolymer layer a uniform and relatively short exposure through the support, thereby photocrosslinking binder and monomer in the support region.

Printing reliefs can be made from a photosensitive composition of this invention by exposing to actinic radiation selected portions of a photosensitive layer through an image-bearing transparency. During the addition-polymerization or cross-linking, the ethylenically unsaturated compound composition is converted to the insoluble state in the radiation-exposed portions of the layer, with no significant polymerization or cross-linking taking place in the unexposed portions or areas of the layer. The unexposed portions of the layer are removed by means of an aqueous or semi-aqueous solvent. The process transparency may be constructed of any suitable material including cellulose acetate film and oriented polyester film.

Actinic radiation from any source and of any type can be used in the photopolymerization process. The radiation may emanate from point sources or be in the form of parallel rays or divergent beams. By using a broad radiation source relatively close to the imagebearing transparency, the radiation passing through the clear areas of the transparency enters as divergent beams and thus irradiates a continually diverging area in the photopolymerizable layer underneath the clear portions of the transparency. This results in a polymeric relief having its greatest width at the bottom of the photopolymerizable layer, i.e., a frustrum, the top surface of the relief being the dimensions of the clear area.

Inasmuch as the free-radical generating systems activatable by actinic radiation generally exhibit their maximum sensitivity in the ultraviolet range, the radiation source should furnish an effective amount of this radiation, preferably having a wavelength range between about 2500Å and 5000Å. Suitable sources of such radiation, in addition to sunlight, include carbon arcs, mercury-vapor arcs, fluorescent lamps with ultraviolet radiation-emitting phosphors, argon glow lamps, lasers, electron flash units and photographic flood lamps. Electron accelerators and electron beam sources through an appropriate mask may also be used. Of these, the mercury-vapor lamps, particularly the sun lamps, are most suitable.

The radiation exposure time may vary from fractions of a second to minutes, depending upon the intensity and spectral energy distribution of the radiation, its distance from the composition and the nature and amount of the composition available. Customarily, a mercury vapor arc or a sunlamp is used at a distance of about 1.5 to about 60 inches (3.8-153 cm) from the photosensitive composition. Exposure temperatures are preferably operated at about ambient temperatures or slightly higher, i.e., about 20° to about 35°C.

Development can be carried out at about 25°C, but best results are sometimes obtained when the developing solution is warm, e.g., 30° to 60°C. Development time can be varied, but it is preferably in the range of about 3 to 25 minutes. Developing solution can be applied in any convenient manner, including immersion, spraying and brush or roller application. Brushing aids in removing the unpolymerized or non-crosslinked portions of the composition. Washout is frequently carried out in an automatic processing unit which uses solvent and mechanical brushing action to remove the unexposed portions of the plate, leaving a relief constituting the exposed image and floor.

Preferred aqueous or semi-aqueous developers contain alkaline material. Suitable alkaline materials include alkali metal hydroxides. A preferred developer is 0.5% sodium hydroxide solution. Semi-aqueous developers also contain a water miscible organic solvent in addition to the alkaline material. Suitable water miscible organic solvents include isopropanol, butanol, diacetone alcohol, 1-methoxyethanol, 2-ethoxyethanol, and 2-n-butoxyethanol. Other aqueous or semi-aqueous developer combinations which can be employed are described in U.S. Patent 3,796,602.

Following, solvent development, the relief printing plates are generally blotted or wiped dry, and then dried in a forced air or infrared oven. Drying times and temperatures vary, but drying for 60 to 120 minutes at 60°C (140°F) is typical. High temperatures are not recommended as shrinkage of the support may cause registration problems. Additional air drying overnight (16 hours or more) is common. Solvent will continue to evaporate from the printing relief during drying at ambient conditions.

Even after drying, however, some photopolymer flexographic printing plates might retain at least some degree of surface tackiness, particularly on the "shoulders" of the relief and other non-image areas. The surface tackiness is undesirable in a printing relief. It is common practice to employ one of several currently known detackification or "finishing" measures. For example, it is well known in the art that chemical treatment with either dilute aqueous chlorine or bromine, or exposure to short wavelength irradiation, can reduce this surface tackiness.

Satisfactory detackification of a photopolymer plate which has been developed in an aqueous or semiaqueous solution can be obtained by applying an aprotic organic solvent to the surface of the plate after drying and prior to exposing the printing surface to radiation with wavelengths in the range of 200 nm to 300 nm. This constitutes the subject matter of Applicant's assignee's U.S. Patent No. 4,806,506, issued on February 21, 1989, and which is hereby incorporated by reference.

In addition to finishing to remove surface tackiness, most flexographic printing plates are uniformly post-exposed to ensure that the photocrosslinking process is complete and that the plate will remain stable during printing and storage. This "post-exposure" utilizes the same ultraviolet radiation source as the main exposure (usually wavelengths of 300 to 420 nm). Post-exposure is used to complete polymerization and maximize plate hardness and durability, but does not remove tackiness. Post-exposure can occur subsequently, simultaneously, and/or prior to light finishing.

The primary purpose of each exposure step is to affect polymerization, and actinic radiation from a variety of sources can be used, including commercial ultraviolet-fluorescent tubes, medium, high and low pressure mercury vapor lamps, argon glow lamps, electronic flash units, photographic flood lamps, pulsed xenon lamps, carbon arc lamps, etc. The radiation source must emit an effective amount of radiation having a wavelength in the range of 230 nm to 450 nm, preferably 300 to 420 nm, and more preferably, 340 to 400 nm. For efficient photopolymerization, the wavelength is matched to the absorption characteristics of the photoinitiator present in the photopolymerizable layers. A standard radiation source is the Sylvania 350 Blacklight fluorescent lamp (FR 48T12/350 VL/VHO/180, 115w) which emits actinic radiation having a central wavelength around 354 nm. Exposure times vary from a few seconds to a few minutes, depending on the output of the lamps, distance from the lamps, relief depth desired, and the thickness of the plate.

The following examples serve to illustrate the practice of the invention. All percentages, ratios and parts are by weight unless otherwise indicated.

### Example 1

This example illustrates the preparation of a release layer according to the invention and a cover sheet using this release layer.

A solution was prepared by slowly adding 360 grams of Klucel® E hydroxypropyl cellulose (10% viscosity in water = 340 mPa.s (340 cps), Aqualon Co., Hopewell, VA), 1.08 grams of Neozapon® Red dye (C.I. Solvent Red 109 and Basic Violet 10; CAS No. 53802-03-2; BASF Wyandott, Holland, MI), and 21 grams of Zonyl® FSN perfluoroalkyl ethoxylate surfactant (E. I. du Pont de Nemours and Company, Wilmington, DE) to 8618 grams of deionized water. The solution was then stirred for four hours at room temperature until all the hydroxypropyl cellulose dissolved. It was then bar coated onto a 0,127 mm (5 mil)thick sheet of polyethylene terephthalate at a rate of 40 feet/min. to give a dry coating weight of 21 mg/square decimeter.

### Example 2

This example illustrates the use of the cover sheet prepared in Example 1 with a photosensitive flexographic printing plate precursor.

The following ingredients were used to prepare the photopolymerizable composition:

| Ingredient | Parts by Weight |
|---|---|
| Butylacrylate/methacrylic acid copolymer (80/20) | 74.7 |
| Hexamethylene glycol diacrylate | 10.0 |
| Polyoxyethylated trimethylol propane triacrylate | 10.0 |
| Dimethoxy phenyl acetophenone | 4.0 |
| 2,6-dimethyl-4-t-butyl phenol | 1.0 |
| TAOBN | 0.05 |
| Hydroxyethyl methacrylate | 0.10 |
| Neozapon® Red Dye (BASF Corp.) | 0.01 |

The above ingredients were fed into a 28 mm twin screw extruder and extruded at 175°C between the cover sheet of Example 1 and a polyvinylidene chloride/acrylic adhesive (76 ResP546, Union Chemical Co., Schaumburg, IL). It was coated onto a 0.108 mm (4 mil) polyethylene terephthalate support. The final thickness (without cover sheet) was 0.635 mm (25 mils).

When the polyester cover sheet was removed prior to imagewise exposure, the release layer remained on the photopolymer layer and exhibited a smooth surface.

The photosensitive element was first back-exposed for 4 seconds, then exposed for 2.0 minutes through a photographic negative on the Cyrel® 30x40 exposure unit (P/N 276208-001 bulbs). It was then processed for 3 minutes in the Cyrel® aqueous processor with a 0.5% aqueous solution of sodium hydroxide at 75°F (24°C), and dried for 20 minutes at 60°C in the Cyrel® dryer. The resulting plate exhibited a relief image with smooth surfaces on solid areas. The depth of the reverse images is given in Table 2.

### Comparative Example 3

This example illustrates the preparation of a cover sheet using a release layer which is not of the invention.

A 12 weight percent solution of polyvinyl alcohol was prepared by slowly adding 1260 grams of 88% hydrolyzed polyvinyl alcohol (Vinol® 205, Air Products Corporation, Allentown, PA) to 9240 g of deionized water. The solution was then heated to 90°C, held at that temp for 30 minutes, and then cooled with stirring to room temperature.

To 1488 g of the 12% polyvinyl alcohol solution was added slowly and with stirring:

| | |
|---|---|
| 31.5 g | polyethylene glycol, MW=1000 (Carbowax® 1000, Union Carbide Corp., Danbury, CT) |
| 7.8 g | Zonyl® FSN |
| 0.99 g | Neozapon® Red dye pre-dissolved in 13.8 g methanol |
| 1458 g | deionized water |

The solution was stirred for an additional 30 minutes. It was then bar coated onto a 0.127 mm (5 mil) thick sheet of polyethylene terephthalate at a rate of 100 feet per minute to give a dry coating weight of 20 mg/square decimeter.

### Comparative Example 4

This example illustrates the use of the element of Comparative Example 3 as compared to the use of the photosensitive aqueous flexographic printing plate precursor of Example 2. The photosensitive composition was prepared as described in Example 2 and extruded between the polyvinyl alcohol coated cover sheet of Comparative Example 3 and a 0.108 mm (4 mil) adhesive coated polyethylene terephthalate support. The final thickness (without the cover sheet) was 0.635 mm (25 mils).

The polyester cover sheet was removed and the photosensitive element was then exposed and developed as described in Example 2. The depth of the reverse images is given in Table 2.

**Table 2**

| Plate | 0.127mm (5 mil) Line | Depth (µm) |
|---|---|---|
| | | 0.084mm (3.3 mil) Diameter Dot |
| Example 2 | 51-53 | 18 |
| Comparative Example 4 | 38-41 | 8-13 |

It is clear from the above data that printing plates with the release layer of the invention have deeper reverse images than plates with a polyvinyl alcohol release layer.

### Example 5

This example illustrates the preparation of a release layer according to the invention and preparation of a cover sheet using this release layer.

A was prepared by slowly adding 12.0 g Klucel® L hydroxypropyl cellulose (50% viscosity in water = 75-150 mPa·s (75-150 cp), Aqualon Co., Hopewell, VA) and 0.25 g Zonyl® FSN to 192 g deionized water. The solution was then stirred for 4 hours at room temperature until all the hydroxypropyl cellulose dissolved. It was then coated on 5 mil polyethylene terephthalate with a coating knife to give a 0.108 mm (4 mil) wet coating thickness. The dry coating weight was approximately 20 mg/dm.

### Example 6

This example illustrates the use of the cover sheet prepared in Example 5 with a photosensitive flexographic printing plate precursor.

The following ingredients were used to prepare the photosensitive composition:

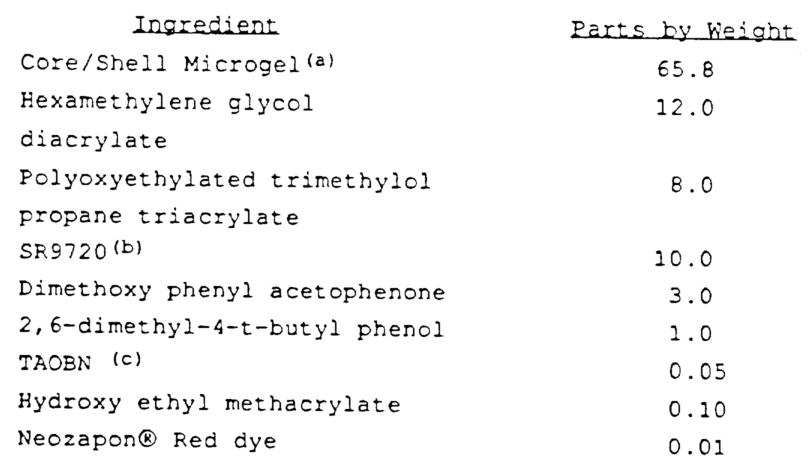

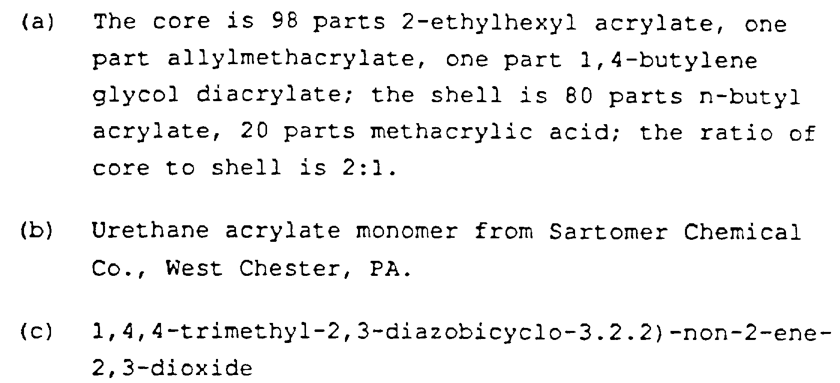

The above ingredients were fed into a 28 mm twin screw extruder and extruded between a polyethylene terephthalate cover sheet coated with 85/15 Vinol® 205/Carbowax® 1000 release layer and a 0.108 mm (4 mil) polyethylene terephthalate support coated with 76 ResP546 adhesive. The release layer was removed by washing with water. The cover sheet and release layer of Example 5 were laminated onto the surface of the extruded polymer. The final plate thickness was 0.635 mm (25 mils).

The photosensitive element was then exposed on the Cyrel® 30x40 exposure unit with exposure lamp P/N 276208-001. The plate was first back-exposed through a yellow filter for 15 seconds, then exposed for 2.5 min through a negative transparency. The plate was then processed as in Example 2. The resulting plate exhibited a relief image with smooth surfaces on solid areas. The depth of reverse images is given in Table 3.

### Comparative Example 7

The polyvinyl alcohol solution of Comparative Example 3 was extrusion die coated onto 0.127 mm (5 mil) polyethylene terephthalate to give a dry coating weight of approximately 40 mg/ dm. The coating was laminated onto the surface of the extruded photopolymer from Example 6 and exposed and processed as described in Example 6. The depth of reverse images is given in Table 3.

**Table 3**

| Plate | 0.127 mm (5 mil) line Depth (µm) |
|---|---|
| Example 6 | 23-25 |
| Comparative Example 7 | 8 |

It is clear from the above data that printing plates with the release layer of the invention have deeper reverse images than plates with a polyvinyl alcohol release layer.

## Claims

1. A method to facilitate removal of a negative or positive image-bearing film from an aqueous or semi-aqueous processible flexographic printing element which comprises using a hydroxyalkyl cellulose release layer interposed between the image-bearing film and a photosensitive layer of the element, wherein the alkyl group has from one to five carbon atoms.

2. A method according to claim 1 wherein the release layer comprises hydroxypropyl cellulose.

3. A method according to claims 1 or 2 wherein the release further comprises a surfactant.

4. A method according to claims 1, 2 or 3 wherein the release layer further comprises a colorant.

5. An aqueous or semi-aqueous processible photosensitive element which comprises a support; a layer of a photosensitive composition; said composition comprising:
(a) an aqueous or semi-aqueous processible binder;
(b) at least one addition polymerizable ethylenically unsaturated monomer;
(c) an initiator activatable by actinic radiation; and a flexible cover sheet,
wherein a hydroxyalkyl release layer is interposed between the cover sheet and the layer of photosensitive composition, said alkyl group having from one to five carbon atoms.

6. An element according to claim 5 wherein the release layer is hydroxypropyl cellulose.

7. An element according to claims 5 or 6 wherein the release layer also comprises a surfactant.

8. An element according to claims 5, 6 or 7 wherein the release layer further comprises a colorant.

9. A process for making a printing relief from an aqueous or semi-aqueous processible flexographic photosensitive element comprising a layer of an aqueous or semi-aqueous processible photosensitive composition containing at least one ethylenically unsaturated photopolymerizable monomer; a photoinitiator activatable by actinic radiation; and an aqueous processible binder; said process including
(a) imagewise exposing the element through a negative or positive image-bearing film;
(b) removing the unexposed portions; and
(c) drying the product of step (b); wherein hydroxyalkyl cellulose release layer is interposed between the image-bearing film and the layer of photosensitive composition prior to step (a), and further wherein the alkyl group has from one to five carbon atoms.

10. A process according to claim 9 wherein post development treatment is applied.

11. A process according to claim 9 wherein the release layer is hydroxypropyl cellulose.

12. A process according to claims 9 or 11 wherein the release layer further comprises a surfactant.

13. A process according to claims 9, 11 or 12 wherein the release layer further comprises a colorant.

## Patentansprüche

1. Verfahren zur Erleichterung des Entfernens eines bildtragenden Negativ- oder Positivfilms von einem wässrig oder halbwässrig verarbeitbaren flexographischen Druckelement, umfassend die Verwendung einer Hydroxyalkylcellulose-Trennschicht, die zwischen dem bildtragenden Film und einer lichtempfindlichen Schicht des Elements angeordnet ist, wobei die Alkylgruppe ein bis fünf Kohlenstoffatome hat.

2. Verfahren nach Anspruch 1, wobei die Trennschicht Hydroxypropylcellulose umfaßt.

3. Verfahren nach Anspruch 1 oder 2, wobei die Trennschicht weiterhin ein Tensid umfaßt.

4. Verfahren nach Anspruch 1, 2 oder 3, wobei die Trennschicht weiterhin ein farbgebendes Mittel umfaßt.

5. Wässrig oder halbwässrig verarbeitbares lichtempfindliches Element, das einen Träger; eine Schicht aus einer lichtempfindlichen Zusammensetzung umfaßt, wobei die Zusammensetzung
(a) ein wässrig oder halbwässrig verarbeitbares Bindemittel;
(b) wenigstens ein additionspolymerisierbares ethylenisch ungesättigtes Monomer;
(c) einen Initiator, der durch aktinische Strahlung aktivierbar ist; und eine biegsame Deckfolie
umfaßt, wobei eine Hydroxyalkyl-Trennschicht zwischen der Deckschicht und der Schicht aus lichtempfindlicher Zusammensetzung angeordnet ist, wobei die Alkylgruppe ein bis fünf Kohlenstoffatome hat.

6. Element nach Anspruch 5, wobei die Trennschicht Hydroxypropylcellulose ist.

7. Element nach Anspruch 5 oder 6, wobei die Trennschicht auch ein Tensid umfaßt.

8. Element nach Anspruch 5, 6 oder 7, wobei die Trennschicht weiterhin ein farbgebendes Mittel umfaßt.

9. Verfahren zur Herstellung eines Druckreliefs aus einem wässrig oder halbwässrig verarbeitbaren flexographischen lichtempfindlichen Element, umfassend eine Schicht aus einer wässrig oder halbwässrig verarbeitbaren lichtempfindlichen Zusammensetzung, die wenigstens ein ethylenisch ungesättigtes photopolymerisierbares Monomer; einen durch aktinische Strahlung aktivierbaren Photoinitiator und ein wässrig verarbeitbares Bindemittel umfaßt; wobei das Verfahren
(a) das bildweise Belichten des Elements durch einen bildtragenden Negativ- oder Positivfilm;
(b) das Entfernen der unbelichteten Bereiche; und
(c) das Trocknen des Produkts aus Schritt (b);
umfaßt, wobei eine Hydroxyalkylcellulose-Trennschicht zwischen dem bildtragenden Film und der Schicht aus lichtempfindlicher Zusammensetzung vor Schritt (a) angeordnet wird und wobei weiterhin die Alkylgruppe ein bis fünf Kohlenstoffatome hat.

10. Verfahren nach Anspruch 9, wobei eine Nachentwicklungs-Behandlung angewandt wird.

11. Verfahren nach Anspruch 9, wobei die Trennschicht Hydroxypropylcellulose ist.

12. Verfahren nach Anspruch 9 oder 11, wobei die Trennschicht weiterhin ein Tensid umfaßt.

13. Verfahren nach Anspruch 9, 11 oder 12, wobei die Trennschicht weiterhin ein farbgebendes Mittel umfaßt.

## Revendications

1. Un procédé pour faciliter le détachement d'un film portant une image négative ou positive d'un élément d'impression flexographique susceptible de recevoir un traitement aqueux ou semi-aqueux, qui comprend l'utilisation d'une couche anti-adhésive d'hydroxyalkyl cellulose intercalée entre le film portant l'image et une couche photosensible de l'élément, dans lequel les groupes alkyles comportent 1 à 5 atomes de carbone.

2. Un procédé selon la revendication 1, dans lequel la couche anti-adhésive comprend de l'hydoxypropyl cellulose.

3. Un procédé selon la revendication 1 ou 2, dans lequel la couche anti-adhésive comprend en outre un agent tensioactif.

4. Un procédé selon les revendications 1 ou 2 dans lesquels la couche anti-adhésive comprend en outre un colorant.

5. Un élément photosensible susceptible de recevoir un traitement aqueux ou semi-aqueux qui comprend un support; une couche de composition photosensible; ladite composition comprenant
(a) un liant susceptible de recevoir un traitement aqueux ou semi-aqueux;
(b) au moins un monomère à insaturation éthylénique polymérisable par addition;
(c) un initiateur activable par une radiation actinique, et une feuille protectrice souple,
dans lequel on intercale une couche hydroxyalkylée anti-adhésive entre la feuille protectrice et la couche de composition photosensible, ledit groupe alkyle comportant de 1 à 5 atomes de carbone.

6. Un élément selon la revendication 5, dans lequel la couche anti-adhésive est une hydroxypropyl cellulose.

7. Un élément selon les revendications 5 ou 6, dans lequel la couche anti-adhésive comprend en outre un agent tensioactif.

8. Un élément selon les revendications 5, 6 ou 7 dans lequel la couche anti-adhésive comprend en outre un colorant.

9. Un procédé de fabrication d'une matrice d'impression en relief, à partir d'un élément photosensible flexographique susceptible d'être traité par voie aqueuse ou semi-aqueuse, comprenant une couche de composition photosensible susceptible d'être traitée par voie aqueuse ou semi-aqueuse, contenant au moins un monomère à instauration éthylénique photopolymérisable, un photoinitiateur activable par une radiation actinique et un liant susceptible d'être traité par voie aqueuse, ledit procédé comprenant:
(a) l'exposition à la manière dont on forme une image de l'élément à travers un film portant une image négative ou positive;
(b) l'élimination des parties inexposées; et
(c) le séchage du produit de l'étape (b),
dans lequel on intercale une couche anti-adhésive d'hydroxyalkyl cellulose entre le film portant l'image et la couche de composition photosensible avant l'étape (a) et en outre dans lequel le groupe actif comporte de 1 à 5 atomes de carbone.

10. Un procédé selon la revendication 9, dans lequel on applique un traitement après développement.

11. Un procédé selon la revendication 9, dans lequel la couche anti-adhésive est une hydroxypropyl cellulose.

12. Un procédé selon la revendication 9 ou 11, dans lequel la couche anti-adhésive comprend en outre un agent tensioactif.

13. Un procédé selon les revendications 9, 11 ou 12, dans lequel la couche anti-adhésive comprend en outre un colorant.
